(19) Europäisches Patentamt
European Patent Office
Office européen des brevets

(11) EP 0 648 392 B1

(12) **EUROPEAN PATENT SPECIFICATION**

(45) Date of publication and mention of the grant of the patent:
**20.08.1997 Bulletin 1997/34**

(21) Application number: **93913448.2**

(22) Date of filing: **29.06.1993**

(51) Int Cl.6: **H04B 10/14**, H03B 17/00

(86) International application number:
**PCT/GB93/01353**

(87) International publication number:
**WO 94/00928 (06.01.1994 Gazette 1994/02)**

# (54) OPTICAL SOURCE FOR COMMUNICATIONS SYSTEM

OPTISCHE QUELLE FÜR EIN KOMMUNIKATIONSSYSTEM

SOURCE OPTIQUE POUR SYSTEME DE COMMUNICATION

(84) Designated Contracting States:
**DE ES FR GB IT NL SE**

(30) Priority: **29.06.1992 EP 92305964**
**05.08.1992 EP 92307150**
**04.09.1992 GB 9218742**

(43) Date of publication of application:
**19.04.1995 Bulletin 1995/16**

(73) Proprietor: **BRITISH TELECOMMUNICATIONS public limited company**
**London EC1A 7AJ (GB)**

(72) Inventor: **WALKER, Nigel, Gordon**
**4 Meadow Close**
**Ipswich Suffolk, IP10 OUL (GB)**

(74) Representative: **Roberts, Simon Christopher et al**
**BT Group Legal Services,**
**Intellectual Property Department,**
**8th Floor, Holborn Centre**
**120 Holborn**
**London EC1N 2TE (GB)**

(56) References cited:
**EP-A- 0 025 491**
**US-A- 4 503 403**
**US-A- 5 042 086**

- **ELECTRONICS LETTERS, vol. 21, no. 18, 29th August 1985, STEVENAGE GB pages 814 - 815 GOLDBERG ET AL '35 GHz Microwave Signal Generation With an Injection-locked Laser Diode'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

The present invention relates to an optical source for a communications system and finds particular application in supplying high frequency signals to a photodetector.

It is known to use a semiconductor laser structure as a signal source in optical communications. Such structures usually comprise an active layer of semiconductor material into which electrical carriers are injected by applying a drive current. The active layer is provided with optical confinement and feedback. The injected carriers produce photons in the active layer which oscillate and multiply by laser action to produce an optical output, often from an end facet of the laser structure.

It is known that, in distributed feedback (DFB) lasers, it is possible to superimpose modulation on the optical output of a laser by varying the drive current. Because of physical limitations of the devices, this has only been done at rates up to about 20GHz. It is also known that as the drive current power increases, optical sidebands are seen, separated by the optical modulation frequency. As the optical frequency deviation of the source increases, more sidebands are produced, reflecting an overall spectral spreading of the modulated source.

On a photodetector a received electrical signal is produced which is given by the (phasor) sum of the beat signals generated between all pairs of optical sidebands. The received electrical signal therefore contains components at multiple harmonics of the modulating frequency. However, a frequency modulated (FM) or phase modulated (PM) optical signal results in an electrical signal containing only a D. C. (zero frequency) component: the summation of beat signals between sidebands exactly cancels to give zero for the electrical signal components at the modulation frequency and higher harmonics thereof. Hence, although high frequency beat signals are present, they do not manifest themselves at a conventional photodetector based receiver. In the paper entitled "35GHz Microwave Signal Generation with an Injection-locked Laser Diode", published in Electronics Letters 29th August 1985 vol 21 no. 18, L Goldberg et al describes a system for generating 35GHz signals by injection locking a slave laser to sidebands of a modulated master laser output. Using a slave laser which has free-running modes separated by a frequency difference which equals a selected beat frequency between sidebands of the master laser, an output is generated from the slave laser which comprises two relatively high amplitude signals separated by that same beat frequency. At a receiver, the beat frequency appears. However, two laser devices are required and it can be difficult to achieve a workable arrangement, it being necessary to provide close wavelength control. It is also difficult to achieve requisite modes in the slave laser, spacing of modes being limited by the length of the device.

In EP-A-025491, which is classified in IPC G01J 3/42, there is described a method and apparatus for detecting one or more spectral features in a sample. The method for detecting a single narrow spectral feature in a sample includes the steps of providing a beam of light having an optical frequency bandwidth which is narrow compared to the width of the narrow spectral fetaure and having a centre frequency $\omega_c$ which lies near the narrow spectral feature, phase modulating the beam of light with a single RF frequency to provide a pure FM spectrum having upper and lower sidebands, exposing the sample containing the narrow spectral feature to the modulated light so that only one of the FM sidebands probes the narrow spectral feature, photodetecting the light emerging from the sample to detect a RF beat at the specific RF frequency used for phase modulation, and electronically monitoring the amplitude of the RF beat signal to indicate the strength of the narrow spectral feature. A preferred embodiment is an apparatus for multiplex readout of information encoded by the presence or absence of photochemical holes burned in an inhomogeneous absorption band of a sample. The apparatus includes means for using a frequency modulated laser light with widely spaced sidebands arranged so that only one of each pair of upper and lower sidebands probes the frequency location of each hole. The apparatus uses many simultaneous RF frequencies to drive the phase modulator and produce the light with FM sidebands which simultaneously probes all the hole locations of interest. The apparatus includes photodetection means to receive the light after it has passed through the samples and phase sensitive multiplex analysing means to process the electrical signals from the photodetection means to indicate the presence or absence of holes.

Embodiments of the present invention can be used to generate photo-detectable signals at microwave frequencies, for instance up to of the order of 60GHz or greater.

Further, it has been found that these detectable signals can be modulated to carry information, such as video, signals and, using a photoelectric detector for instance, the output from a receiver receiving such signals can be fed directly to a microwave antenna, such as a horn, providing an optically driven microwave link.

Embodiments of the present invention also have the advantage that they can be fabricated to form only a small dimensioned package which is particularly convenient in certain environments.

According to the present invention, there is provided an optical communications system comprising:-

a optical signal source, said source in use having an optical output, modulation means to produce angle modulation in said optical output at a modulation frequency and thereby cause optical sidebands to appear in the optical output, modifying means to modify a relative characteristic of the optical sidebands in the optical output and thereby allow photodetection of at least one harmonic of said modulation at a receiver receiving said optical output,

and a receiver for receiving and photodetecting said optical output to produce at least one radio-frequency harmonic of said modulation frequency.

In particular, said characteristic might be a phase or amplitude characteristic of the optical output. That is, it has been recognised that including modifying means which modifies the phase (or amplitude) of the FM or AM sidebands of the optical source effectively "uncancels" the beating between optical sidebands, thereby producing a received electrical signal with components at harmonics of the original modulating frequency.

As mentioned above, it has also been discovered that such harmonics can be modulated to carry information signals such as video signals, and the output from a detector, or at least from a receiver incorporating a detector, can be used to feed a microwave antenna directly, so that an optical fibre fed, information signal carrying microwave link is produced.

Other aspects of the present invention are defined in the claims.

A convenient means for modifying phase characteristics of one or more of the sidebands comprises dispersive optical fibre. The different sidebands will be phase shifted so that the beat frequencies between them, the "harmonics" of the modulation frequency, can be picked up by the photodetector. For instance, if the laser source is driven with a 4GHz FM signal and the output passed through 12.5km of conventional step index fibre, phase shifted optical sidebands received at a detector will beat to produce a photo current comprising a frequency comb with 4GHz spacing. In the detector, the frequency comb will produce harmonics significantly above 4GHz, for instance at 40GHz, as a result of beating between optical sidebands spaced by 10 x 4GHz.

In a possible application, the output of the detector can then be fed to a microwave antenna and propagated as a radio frequency (RF) signal in free space thereby. The beat frequency (e.g. 40GHz) signal is then conventionally detected at a receiving microwave antenna, mixed to a local oscillator to downconvert to an intermediate frequency, amplified and fed to an intermediate frequency (IF) receiver.

Notably, in embodiments of the present invention where dispersive phase shifting is used to achieve harmonic detection at the photodetector, all the sidebands are contributing to the RF signal. This is in contrast to the 1985 disclosure of Goldberg et al, referenced above.

Embodiments of the present invention will now be described, by way of example only, with reference to the accompanying figures, in which:

Figure 1 shows a schematic diagram of a first arrangement of an optically fed microwave link carrying a video signal and comprising an optical signal source according to an embodiment of the present invention;
Figure 2 shows a graph of modulation depth at the output of an optical detector, detecting the output of the optical source of Figure 1 after optical phase shifting by transmission on a dispersive optical fibre;
Figure 3 shows in graphic form a definition of a Bessel function Jp for a variable x;
Figure 4 shows in more detail the steps in providing a modulated drive current to a laser structure in an optical signal source as shown in Figure 1;
Figure 5 shows a schematic diagram of a second arrangement of an optically fed microwave link carrying a video signal and comprising an optical signal source according to an embodiment of the present invention.
Figure 6a) shows a graph of a theoretical relationship between modulation depth and FM modulation index for a range of beat frequencies, or harmonics 10 through 15 of a modulation signal; and
Figure 6b) shows a graph of measured dependence of modulation depth on drive current to a laser structure for the harmonics of Figure 6.

Optical fibre and millimetre-wave radio are both capable of supporting large bandwidth requirements, for instance as associated with broad band services. Running optical fibre direct to a home or business can provide high capacity but is not always an appropriate solution for operational reasons. It is likely that a hybrid network comprising both radio and fibre will play a significant role in early broadband local access systems.

Radio transmission in the 60GHz millimetre-wave region is of special interest because an oxygen absorption peak aids frequency re-use in a cellular communications environment. In addition, high gain antennae are physically small at this frequency and could be manufactured cheaply in volume for consumer applications. However, practical issues such as cost, size, weight, frequency stability and power consumption of radio outstations need to be addressed before hardware could be deployed to provide broadband services at millimetre-wave frequencies.

In both arrangements of the present invention described herein direct modulation is applied to a single mode semiconductor laser to create an optical FM signal. Dispersion in an optical fibre then perturbs the phase relationships between the FM side bands in such a way that the output from the photodetector provides significant power levels at high order harmonics of the modulation frequency. With a modulation frequency of 4GHz, considerable power is obtained beyond the 15th harmonic, that is at frequencies in excess of 60GHz. Unwanted harmonics could be removed easily if necessary by electrical filtering after photodetection.

It should also be noted that, because the optical FM side bands are derived from the same optical mode, the optical phase noise is cancelled at the photodetector. Therefore the phase noise is principally determined by that of the modulating source. The combination of efficient harmonic generation, high spectral purity, compact size, and the ability to choose any frequency (at least to 60GHz) makes this a most attractive technique for the transmission of millimetre-wave radio signals over optical fibre.

Referring to Figure 1, the first arrangement of an optical fed microwave link of the present invention comprises a laser source 1, supplied with a drive current by a frequency modulated current source 2, the laser output being fed via a dispersive fibre link 3 to an optical detector 4. A video signal is superimposed on the FM output of the current source 2 by a video pattern generator 11. The electrical output of the detector 4 is fed to a microwave transmitter 5 which generates a free space signal link 6 to a microwave receiver 7 whose electrical output is down converted, amplified and fed to a video receiver 8 according to known techniques.

The laser source 1 comprises a single mode DFB laser, being a bulk device with grating feedback. The optical detector 4 comprises a high gain, high speed detector as disclosed in International Patent Application number GB91/00702 WO, filed on 1st May 1991, priority date 1st May 1990, in the present Applicant's name. The fibre link 3 comprises 12.5km of conventional step-index single-mode fibre.

If the laser source 1 is driven by a signal at 4GHz, the signal received at the optical detector 4 from the dispersive fibre link 3 will contain optical sidebands, phase shifted to produce a photo current output from the detector 4 comprising a frequency comb with 4GHz spacing. In the detector, the frequency comb will include a beat frequency at 40GHz from signals at 10 x 4GHz separation. That 40GHz beat frequency can be filtered and fed directly to the microwave transmitter 5. At the receiver 7, the 40GHz signal can be mixed and downconverted to an intermediate frequency using conventional techniques. The downconverted component may then be passed through an amplifier 15, split and fed to the video receiver 8, the other part of the signal output from the splitter 9 being used to supply a spectrum analyser 10 for monitoring purposes.

In the system described above, effectively the tenth harmonic of the 4GHz modulating signal has been selected.

## CONSTRAINTS AND OPERATING CHARACTERISTICS

There are a number of constraints and characteristics of the system described above and these are as follows.

### Frequency Deviation

Referring still to Figure 1, the video receiver 8 requires a FM input of approximately 13MHz deviation. Using a synthesiser as the current source 2 to produce a 4GHz frequency modulated drive current to the laser source 1, the video pattern generator 11 is used to modulate that 4GHz "carrier". To achieve the 13MHz deviation at the video receiver input, the frequency deviation at the output of the current source 2 should be approximately 1.3MHz in view of the use of the tenth harmonic. The video pattern generator 11, having a nominal output of 1v, is used to drive the FM input of the current source 2, or synthesiser, via a 75/50 Ohm matching pad 14.

### 4GHz FM to 40GHz AM Conversion Efficiency

Referring to Figure 2, in selecting the tenth harmonic, there is a conversion at the optical detector 4 not only in frequency but also in signal type. That is, the 4GHz optical FM signal transmitted by the laser source 1 becomes a 40GHz electrical signal at the output of the optical detector 4.

In Figure 2, the modulation depth "M" at the output of the optical detector 4 can be defined as the ratio of the amplitude of the harmonic $I_{ac}$ to the direct current photo current $I_{dc}$. This is seen in Figure 2 as the peak height of the modulation $I_{ac}$ with respect to the base level 12 provided by the dc photo current $I_{dc}$.

The modulation depth can however be arrived at by a separate analysis, as follows.

The modulation depth, $M_p$, of the pth harmonic is given by

$$M_p = 2\,J_p\,(2\beta \sin (p\theta)) \qquad 1$$

where

$J_p$ is the pth bessel function
$\beta$ is the FM index of the laser and
= Fdeviation/Fmodulation

θ is an angle characterising the dispersion in the fibre.

The dispersion angle, θ, is given by

$$\theta = (2\,\pi\,F_{mod})^2 \times (-DZ\lambda\,\frac{\lambda}{4\pi c}) \qquad 2$$

where

$F_{mod}$ = laser modulation frequency
= 4GHz in the example
D = fibre dispersion in ps/km/nm
Z = fibre length
λ = free space wavelength of light
c = speed of light.

According to equation 1, the maximum modulation depth of the pth harmonic equals twice the maximum value of the pth bessel function.

Referring to Figure 3, values of the bessel function $J_p$ for a variable x can be defined as shown. Using this nomenclature, then the greatest modulation depth for the pth harmonic is given by

$$M_p\,(max) = 2\,J_p\,(j'p,\,1)$$

and occurs when

$$2\beta\,\sin\,(p\theta) = j'p,\,1$$

The values of p, (j'p,1), & $J_p$(j'p, 1) are tabulated as follows:

| p | j'p,1 | Jp(j'p,1) |
|---|---|---|
| 0 | 0 | 1 |
| 1 | 1.84118 | .58187 |
| 2 | 3.05424 | .4865 |
| 3 | 4.20119 | .43439 |
| 4 | 5.31755 | .39965 |
| 5 | 6.41562 | .37409 |
| 6 | 7.50127 | .35414 |

| | | |
|---|---|---|
| 7 | 8.57784 | .33793 |
| 8 | 9.64742 | .32438 |
| 9 | 10.71228 | .3128022 |
| 10 | 11.7717 | .3027425 |
| 11 | 12.82729 | .2938809 |
| 12 | 13.87962 | .285987 |
| 13 | 14.92913 | .2788889 |
| 14 | 15.97618 | .2724552 |
| 15 | 17.02105 | .2665838 |
| 1b | 18.06397 | .2611935 |
| 17 | 19.10516 | .2562191 |
| 18 | 20.14477 | .2516072 |
| 19 | 21.18294 | .2473137 |
| 20 | 22.21981 | .243302 |

Theoretically, using the tenth harmonic, the maximum modulation depth that could be achieved was 60%. However, in practice, significantly lower modulation depth might be achieved, for instance of the order of 13%.

It might be noted that $\beta$ gives an approximate threshold value for appearance of the "nth" harmonic at $\beta$ approximately equal to n/2.

Fibre Length and Dispersion

The dispersion, $\theta$, produced by the fibre link 3, has been set out above at equation 2. Putting in the following experimental values, a length of 12.5km for the dispersive fibre link 3 was found to be adequate to give significant phase shifting between sidebands.

$F_{mod}$ = 4GHz
D = 17 ps/km/nm (dispersion)
z = 12.5km (length of fibre)
$\lambda$ = 1550 nm (optical signal wavelength)

This gives a value for $Dz\lambda$ of 329nS. $\lambda/c$ is 5.17 x $10^{-b}$ nS. Therefore, $\theta$, by substitution in equation 2, = 2 $\pi$ x 2. 72 x $10^{-2}$/2.

$$p\theta = 10\theta = 2\pi \times 0.272$$

$$= 0.27\pi$$

For the tenth harmonic, it is desired that $p\theta = 0.5\pi$. However, from the above, we have $p\theta = 0.27\pi$

This gives $\sin(p\theta) = \sin(0.27\pi) = 0.75$

The value of $p\theta = 0.5\pi$ is optimum in the sense that this value minimises the modulating power that has to be applied to the laser in order to maximise the 40GHz component. In the present experiment, z at 12.5km represented about half the optimum length of fibre, but this can be compensated by an increase in the modulation index, $\beta$.

FM Deviation of Laser

Going back to equation 1, $M_p$ is maximum when

$$2\beta \sin(p\theta) = j'p, 1$$

$$= 11.77 \text{ for } p=10$$

This gives an estimated value of $\beta$ at approximately 7. 8.

The laser drive power at 13. 8dBm, 24mW gives a zero to peak current amplitude of 31mA.

The FM deviation of the laser is given by Fdev = β x 4GHz = 31.4GHz, so the laser FM efficiency is given by

$$\frac{\Delta F}{\Delta i} = 1\text{GHz/mA}$$

RF Propagation

Using a separation of 0.5m between the microwave transmitter 5 and the receiver 7, the measured loss across the free space signal link 6 was 19. 0dB. Theoretically, with a path loss across the link 6 of 60dB, and antenna gains at the microwave transmitter and receiver 5, 7 of 21.5dB each, one would expect the net loss to be 17.0dB. (It should be noted however that 0. 5m is not a distance clearly related to either the near or the far fields in these circumstances and the estimate at 17.0Bb for the net loss can only be treated as approximate.

Down Conversion

Loss at the downconverter 13, the measured power loss from the 40GHz signal from the microwave receiver 7 to the intermediate frequency signal output by the down- converter 13, was measured as 11. 7dB, using a 9. 6dBm 39GHz input at the LO part of the down-converter 13.

Video FM Transfer

Referring to Figure 4, there is a voltage reduction $V_2/V_1$ due to the 75/50 Ohm matching pad 14 of 0.424, for a video output of $V_1$ at 1V. Using a synthesiser 2 set to give 4.65MHz/RMS (Root Mean Square) Volt, the FM deviation "δf" per Volt at $V_2$ is given by

$$\delta f/V_2 = (1/\sqrt{2}) \times 4.65$$

giving

$$\delta f/V_1 = (1/\sqrt{2}) \times 4.\ 65 \times 0.424$$

$$= 1.\ 52\text{MHz/V}.$$

The FM transfer coefficient was measured directly for the 4GHz and 40GHz components:

| | $\Delta V_{pk\text{-}pk}$ | $\Delta f_{pk\text{-}pk}$ | $\Delta f/\Delta V$ |
|---|---|---|---|
| 4GHz | 1. 0V | 1. 38MHz | 1.38MHz/V |
| 40GHz | 150mV | 2. 04MHz | 13.3MHz/V |

This gave a measured FM transfer coefficient at 40GHz of 13. 3MHz/V compared with a calculated value of 15.2MHz/V.

Other Factors

Looking at the threshold sensitivity of the video receiver 8, the calculated threshold sensitivity was found to be -86dBm. The experimental threshold was found to be -85dBm. No significant extra noise is introduced by the optical link but it is thought that the line amplifier 15 may have a small effect.

Concerning gain at the line amplifier 15 and the splitter 9, the combined gain was found to be 4dB.

Power budget

Factors in the power budget at the microwave transmitter 5 are as follows:

| | |
|---|---|
| Reference (0dBm optical power) | = -14.1 |

(continued)

| | |
|---|---|
| Optical input power (twice -1dBm) | = -2.0 |
| Responsivity | = +5.2 |
| Ideal modulation depth | = -10.5 |
| FM/AM inefficiency | = -7. 0 |
| Detector roll off | = -12.5 |
| 50 Ohm matching | = 0.0 |
| Electric power | = -40. 9dBm |

Including the rest of the system, the power budget is then as follows:

| | |
|---|---|
| | = -40. 9dBm |
| Path loss (0. 5m) | = -60.0dB |
| Transmitter horn gain | = +21.5 |
| Receiver horn gain | = +21.5 |
| Received power | = -57. 9dBm |
| Excess path loss | = 1. 9dBm |
| Net received power | = -59. 8dBm |
| Conversion loss | = -11. 7dB |
| Line amplifier/splitter | = +4.0dB |
| Video received power | = -67. 5dm |
| Threshold power | = -85. 0dBm |
| Margin | = 17. 5dB |

It should be noted that, although a microwave horn is described at the microwave transmitter 5 and the microwave receiver 7, a horn is only one possible type of antenna which might be used in such a transmitter or receiver.

Possible improvements in the system described above might be to increase the microwave transmission range. In order to transmit 100m, an extra 46dB power approximately would be required such that the radio frequency transmitter gave out perhaps +6dBm. In order to increase transmitter power, one might adjust the following:

Detector roll off
optical input powers
impedance matching

Feasibly, one could achieve -10dBm transmitted power, for instance.

Figure 5 shows a second experimental layout for an embodiment of the present invention.

A three contact DFB laser 1 is driven by a microwave oscillator 2 to create an optical FM signal. The microwave oscillator 2 is itself frequency modulated by an input video signal 11. The resulting modulated lightwave is transmitted along 12.5km of standard single mode fibre 3 and detected by a high speed photodetector 4 which in turn drives the radio transmitter antenna 5. At the radio receiver, the incoming signal is down converted to an intermediate frequency (IF) within the band of a satellite TV receiver 8 and then displayed on a video monitor or a spectrum analyzer 10.

The three contact DFB laser 1 comprises a device 350µm long, the outer contacts of which are connected together. The outer contacts are biased at 90mA while the centre contact is biased at 30mA. Under these conditions, the output power (after optical isolation) was 1.6mW at a wavelength of 1556nm, and the FM efficiency (driving the centre contact) was 1.0GHz/mA at the microwave oscillator frequency of 4GHz. The oscillator power was set to a level of +14 dBm, which was found to maximise the magnitude of the tenth harmonic at 40GHz (the highest frequency for which the radio receiver equipment was readily available).

The pigtailed high speed photodetector 4 was a monolithically integrated optical pre-amplifier and edge-coupled PIN photodiode, with a responsivity of 0.61A/W at 40GHz. A bias tee and a waveguide-to-coaxial transition were used to connect the photodiode directly to a standard gain (21.5 dB) horn antenna to form the radio transmitter. The optical power level after the 12.5km of optical fibre was - 1.0 dBm, which produced an electrical power of -40.8 dBm (at 40GHz) at the photodiode output. The 40GHz optical modulation depth at the photodiode was calculated from these values to be 12%. The 3 dB line width of the 40GHz carrier (with the video input signal removed) was less than 10Hz.

After transmission over 1m of free space, the power at the output of the receiver horn 7 was -64.8 dBm. A local oscillator at 39GHz was used to down convert to an IF of 1GHz. The conversion loss was 11.7 dB and the IF power

after the line amplifier and splitter 9 was -72. 5 dBm.

The 4GHz drive frequency to the laser 1 deviates in response to the video input signal connected to the FM input of the microwave source 2. The deviation is reflected in the frequency spacing of the optical FM side bands and the electrical comb at the output of the photodiode in the photodetector 4. Each frequency of the comb deviates in proportion to its harmonic number and the tenth harmonic at 40GHz therefore deviates by ten times the deviation of the 4GHz output of the microwave source 2. The peak FM deviation required by the video satellite receiver unit is approximately 14MHz so the FM coefficient of the microwave source 2 was set to 1. 4MHz/V for the video input signal level of 1Vpk.

The threshold power level of the video receiver was -85.0 dBm, giving a margin of 12.5 dB. The calculated FM threshold power level was -86 dBm, based on a bandwidth of 30MHz, a signal-to-noise ratio of 8 dB, and a receiver noise figure of 5 dB. Close agreement between the experimental and calculated threshold power levels indicates that the noise contributed by the optical link can be ignored in this experimental arrangement.

In practice, a longer radio transmission distance may be necessary. There are a number of improvements which could be made in the arrangement described above. A possibility involves a modified source which would increase the modulation depth at the photodiode in the photodetector 4. It has been shown that the maximum modulation depth obtainable for a source with pure frequency modulation is 60% for the tenth harmonic, and that the discrepancy with the experimental value of 12% is caused by the presence of significant intensity modulation at the output of the laser 1.

Another possibility is improving the responsivity of the photodetector 4. Previous examples of this type of photodetector in a different package (without a fibre pigtail) have shown responsivity values of over 30A/W at 40GHz. Although saturation of the integrated optical amplifier and the current handling capability of the photodiode will set a limit to available output power, a maximum photocurrent of more than 10mA is not unreasonable. If this is combined with a modulation depth of 100%, a millimetre wave power level of more than +4 dBm would be available, which is greater than a 45 db increase over the experimental arrangement described above. Narrow band design and impedance matching at the output of the photodiode may result in further improvement.

Electrical amplification at the photodetector output is an obvious way to increase the radio range, but it may be preferred in practice that an outstationed radio transmitter be kept relatively simple. Improvements in this area might arise from a reduction in the number of components and also a reduction or elimination of their requirements for dc power.

For point to point applications, the use of directional antennae rather than standard gain horns could increase the received millimetre-wave power considerably, again leading to increased radio range. The 45 dB increase in power at the radio transmitter, coupled with 20-30 dB afforded by the use of directional antennae would lead to a total increase in received power of 65-75 dB, and therefore transmission distances greater than 1km would be possible.

The experimental arrangement described above uses the tenth harmonic at 40GHz. In principle, it would be possible to move to 60GHz either by increasing the modulation frequency or by making use of 15th harmonic. Also the system described above only incorporates a single video channel. It may be that embodiments of the present invention would be suitable in multichannel transmission.

To sum up, the arrangement described above demonstrates a simple technique for realizing millimetre-wave radio-fibre systems which does not require either a millimetre-wave source at the optical transmitter 1, or up conversion at the radio transmitter 5. The technique is suitable for transmission of FM signals such as wide band video FM, or continuous wave (CW) signals for remote injection locking applications. The spectral purity of the CW millimetre-wave signal transmitted in this way is determined primarily by that of the microwave oscillator. For practical applications it would be necessary to increase the radio propagation range, but improvements in this area could make 1km a realistic target.

Publications comprising subject matter relevant to the above are as follows:

I C Smith and B J Ellis: "A wide band mm-wave Fibre-fed Radio Distribution Point Demonstrator", ICC92 Conference Record pages 100-104, June 1992.

G Sherlock, H J Wickes, C A Hunter and N G Walker: "High Speed, High Efficiency, Tunable DFB Lasers for High Density WDM Applications", ECOC92, Paper Tu P1.1, September 1992.

D Wake: "A 1550nm millimetre-wave Photodetector with a bandwidth-Efficiency Product of 2.4THz", J Lightwave Technol., vol. 10 pages 908-912, July 1992.

Although the use of the technique for tranmission of FM video information has been described, it should be noted that other methods of impressing information onto the transmitted beat signal are possible. For example, the output of the modulated laser, comprising the optical sidebands, can itself be transmitted through an optical intensity modulator to superimpose the information to be communicated. At the receiver, the electrical signal would then contain beat frequencies between the optical sidebands, each with the information impressed. Such an arrangement might be used, for example, to transmit multiple video channels.

It is important to note that, although the arrangement described above relies on the properties of semiconductor

lasers in generating optical FM, other forms of modulation might be substituted, such as phase modulation.

Further, although dispersive fibre 3 is described, other means for modifying the relative characteristics of the sidebands might be used, such as a grating pair.

Although the embodiments described above comprise a laser source 1, this is not essential, it being within the ambit of the present invention that an optical source be remote and of any of a number of types, it being sufficient for the invention that sidebands of the modulation can be produced, and hence at least one beat frequency.

In a different embodiment of the present invention, the fifteenth harmonic of a 4GHz signal may for instance be detected, giving a beat frequency of 60GHz. An arrangement in which this is the case is described below, together with some further discussion of aspects of the invention.

As described above,

a frequency or phase modulated optical signal becomes intensity modulated through dispersion in single-mode optical fibres. Theoretical results describing this effect are presented below, and supported by observation of 12% intensity modulation at the 60GHz harmonic of a 4GHz signal applied to a three-contact DFB laser.

Chromatic dispersion is known to cause a phase or frequency modulated optical signal to become intensity modulated as it propagates along a single-mode optical fibre [1]. This effect has been identified as causing a power penalty in digital transmission systems, and intermodulation products and noise in analogue systems [2, 3]. The same mechanism also causes signal fading in AM systems [4].

With reference to this following embodiment, we further discuss how dispersion can be used to advantage to generate high frequency mm-wave signals from a source which is frequency or phase modulated at microwave rates. The principle is demonstrated by applying a 4GHz drive current to a split contact DFB laser designed for frequency modulation and observing the 60GHz, 15th harmonic component of the intensity variations at the output of 12.5km of dispersive single mode fibre.

**Theory**

Before considering specifically the case of frequency or phase modulation, we first derive a formula for the harmonic content of the intensity variations of any periodically modulated signal mode optical singal propagated over dispersive fibre. The electric field at the transmitter can be written in the form

$$e_t(t) = f(\omega t)\exp(j v_0 t) \quad (1b)$$

$$= \sum_{n=-\infty}^{\infty} F_n \exp(j(v_0+n\omega)t) \quad (1b)$$

where $v_0$ is the optical angular frequency of the single mode source, $\omega$ is the modulating angular frequency and $f(\theta)$ is a periodic function with harmonic components $F_n$ given by

$$f_n = \frac{1}{2\pi}\int_{-\pi}^{\pi} f(\theta)\exp(-jn\theta)\,d\theta \quad (2)$$

The fibre transfer characteristic can be written in the form

$$H(v) = \exp(-jk(v)z)$$

$$= \exp(-j(k_0+k_1(v-v_0)+½k_2(v-v_0)^2+...)z) \quad (3)$$

where z is the fibre length. In the expansion of the propagation constant k(n), the first two terms represent a fixed phase shift and propagation delay. We retain only the third term (putting $k_0$=$k_1$=0), and write

$$H_n = H(v_0+n\omega) = \exp(-jn^2\phi) \quad (4)$$

where $\phi = ½\omega^2 k_2 z$ parameterises the fibre dispersion at the operating wavelength and modulation frequency. The fibre group delay, $\tau_g$ for light at frequency v is given by

$$\tau_g = z\frac{dk}{dv} = zk_2(v-v_0) \tag{5}$$

and allows $\phi$ to be related to the group velocity dispersion parameter, $D = (d\tau_g/d\lambda)/z$ (normally quoted in ps/(km nm)), as follows [2]

$$\phi = ½\omega^2 k_2 z = -\frac{\omega^2}{4\pi}\frac{D\lambda}{c} z \tag{6}$$

The instantaneous optical intensity received after propagation through the fibre is given by

$$\begin{aligned} i(t) &= \left| e_r(t) \right|^2 \\ &= \left| \sum_{n=-\infty}^{\infty} F_n H_n \exp(j(v_0 + n\omega)t) \right|^2 \\ &= \sum_{p=-\infty}^{\infty} I_p \exp(jp\omega t) \end{aligned} \qquad (7$$

where the $I_p$ are the harmonic components of the intensity variations, and can be evaluated by inserting (4) in (7). Expanding the square as a double sum and collecting terms gives

$$I_p = \exp(jp^2\phi) \sum_{q=-\infty}^{\infty} F^*_{q-p} F_q \exp(-2jqp\phi) \tag{8a}$$

$$= \frac{1}{2\pi} \int_{-\pi}^{\pi} f^*(\theta + p\phi) f(\theta - p\phi) \exp(-jp\theta)\, d\theta \tag{8b}$$

where to obtain (8b), equation (2) along with its inverse has been used. It is worth noting that the relative phase shift, $2p\phi$ between f and $f^x$ in (8b) is the difference in group delay corresponding to an optical frequency difference of $p\omega$, and that the pth component of the intensity fluctuations is equal to the pth component of the delayed product $f^x f$. This result assumes only that the modulation is periodic, and that the dispersion is 'linear' ($k_i = 0, i>2$ in (3)).

Returning to the case of frequency or phase modulation, we put

$$f(\theta) = \exp(j\beta\cos(\theta)) \tag{9}$$

where $\beta$ is the phase deviation, or the frequency modulation index. Inserting (9) into (8b) gives

$$\begin{aligned} I_p &= \frac{1}{2\pi} \int_{-\pi}^{\pi} \exp(j2\beta\sin(p\phi)\sin(\theta)) \exp(-jp\theta)\, d\theta \\ &= J_p(2\beta\sin(p\phi)) \end{aligned} \tag{10}$$

where $J_p(x)$ is the pth Bessel function of the first kind. Equation (10) can also be derived by expanding the FM signal

directly in terms of its Fourier components and applying Graf's addition formula [5] to equation (8a). Finally, we note that, as i(t) is real, $I_{-p} = I_p^*$, so that (7) can be written

$$i(t) = I_0 + \sum_{p=1}^{\infty} 2\left|I_p\right| \cos(p\omega t + \xi_p) \qquad (11)$$

where $\xi_p$ gives the phase of the pth harmonic. On account of (11), we define the intensity modulation depth, $M_p$ for the pth harmonic to be

$$M_p = \left|\frac{2I_p}{I_0}\right| = \left|2J_p(2\beta\sin(p\phi))\right| \qquad (12)$$

Equation (12) conveys the following conclusions. Firstly, the greatest modulation depth that can be obtained at the pth harmonic is equal to twice the greatest value of the corresponding Bessel function. These values fall off quite slowly with increasing p, and (12) predicts 60% modulation depth at the 10th harmonic. Secondly, the FM index required to achieve greatest intensity modulation depth is minimised if the fibre length is chosen such that $p\phi=(n+½)\pi$, n=0, 1,.... Otherwise the FM modulation index can be adjusted to compensate for non-optimum fibre length.

**Experiment**

The possibility of generating significant high frequency intensity modulation was investigated experimentally using a 300 µm long, three-section BH-DFB laser emitting at 1556nm and designed for FM modulation, and 12.5km of conventional step index single mode fibre. The detector was a monolithic pre-amplified edge coupled PIN photodiode with a responsivity (photocurrent/fibre power) of 2A/W at D.C. and 0.28 A/W at 60GHz. The centre section of the laser was modulated at 4GHz, and the output of the photodetector was monitored directly on a 40-60GHz spectrum analyser, enabling the magnitudes of the 10th to 15th harmonics to be measured, and the corresponding intensity modulation depths to be calculated from knowledge of the photodiode response.

The theoretical modulation depth predicted by (12) is plotted as a function of FM modulation index in Figure 6a. A fibre dispersion of D=17pS/(km nm) has been assumed, giving a value of $\phi=0.027\pi$, which is about half the optimum for generating the 10th harmonic. The measured values of modulation depth are shown in Figure 5b plotted as a function of the drive current applied to the laser, and it can be seen that these follow the form of the theoretical curves. The enhanced response of the 48GHz component is thought to be due a resonance in the coupling circuit between the photodetector and RF spectrum analyser. The fact that the measured modulation depths are smaller than the theoretical values has been attributed to the non-ideal FM modulation of the laser. The output of the laser was itself significantly intensity modulated at the drive currents required to generate significant FM-IM conversion at the 10th-15th harmonics, and the effect of this has been modelled by an extension of the analysis presented above, and by a separate method. Both approaches predict a reduction of the maximum intensity modulation depth of one harmonics, as well as a more pronounced rolloff with increasing FM index, as observed in the experimental plots.

By comparing the horizontal scales in Figures 6a and 6b, it can be inferred that the FM responsivity of the DFB laser is about 1.1GHz/mA, and this value was confirmed by direct measurement of the spectral spreading of the modulated source on an optical spectrum analyser.

**Conclusions**

A frequency modulated or phase modulated optical signal becomes intensity modulated when propagating in dispersive fibre. Large modulation depth can be obtained at high harmonics of the modulating frequency, for example it is possible to generate 60% modulation depth of the 10th harmonic. The effect provides a method for generating mm-wave signals at frequencies for which baseband modulators are not available (40-100GHz). The method is simpler to implement than, say, filtering and amplifying individual sidebands of a modulated laser, as it does not require careful alignment of optical wavelengths. Moreover, it is efficient in the sense that optical power is not wasted by rejecting unwanted sidebands. The FM index can be adjusted to accommodate variations in fibre length, and the generated frequencies can also be tuned easily. The technique could find application in the transmission of high frequency radio signals over optical fibres.

## References

[1] A.R. Chraplyvy, R.W. Tkach, L.L. Buhl, R.C.Alferness, 'Phase modulation to amplitude modulation conversion of CW laser light in optical fibres', Electron. Lett. 1986, 22(8), pp.409-411.
[2] G. Meslener, 'Chromatic Dispersion Induced Distortion of Modulated Monochromic Light Employing Direct Detection', IEE Jnl Quantum Electron., 1984, QE-20(10),pp1208-16.
[3] J. Wang, K. Petermann, 'FM-AM conversion effects in dispersive optical fibre lines with respect to analogue and digital systems', Proc 17th ECOC, 9/12 Sept, Paris, Paper WeC8-5, Vol 1, pp573-6.
[4] P.A. Rosher, M. K. Compton, A.D. Georgiou, 'Dispersive considerations in microwave optical systems', Prod IEE Colloquium 'Microwave Optoelectronics' , 26th Oct. 1990, IEE digest 1990/139, pp12.1-12.6.
[5] M. Abramowitz, I. Stegun Eds. 'Handbook of mathematical functions', Dover Publications, New York, ISBN 486-61272-4.

## Claims

**1.** An optical communications system comprising:-

a optical signal source (1), said source in use having an optical output, modulation means (2) to produce angle modulation in said optical output at a modulation frequency and thereby cause optical sidebands to appear in the optical output,
modifying means (3) to modify a relative characteristic of the optical sidebands in the optical output and thereby allow photodetection of at least one harmonic of said modulation at a receiver receiving said optical output,
and a receiver (4) for receiving and photodetecting optical output to produce at least one radio-frequency harmonic of said modulation frequency.

**2.** A system according to claim 1, wherein the modifying means comprises a dispersive optical fibre.

**3.** A system according to Claim 1 or claim 2, wherein said optical signal source is a distributed feedback laser.

**4.** A system according to Claim 3, wherein said optical signal source is a split-contact distributed feedback laser.

**5.** A system according to any one of Claims 1 to 4, wherein the modulation means is operatively connected to an information source to enable the imposition of an information component onto the optical output and hence onto said radio frequency harmonic.

**6.** A system according to Claim 5, wherein said information source comprises a source of video signals.

**7.** A system according to any one of Claims 1 to 6, further comprising a microwave antenna (5) which in use receives the said at least one harmonic of said modulation frequency subsequent to photodetection by the receiver (4).

**8.** A radio frequency signal source for use in a communications system, the source comprising an optical signal source (1) which, in use, has an optical output, modulation means (2) to produce angle modulation in said optical output and thereby cause optical sidebands to appear in the optical output, and modifying means (3) comprising a length of dispersive optical fibre to modify the relative phases of the optical sidebands in the optical output and thereby allow photodetection of at least one RF beat frequency between said sidebands at a receiver (4) receiving said optical output, and means to output said RF beat frequency from the receiver for use in a radio communications system.

**9.** A source according to Claim 8, wherein an information source is operatively connected to the modulation means to enable an information-carrying modulation to be applied to the optical output and for an information component thereby to be passed to said receiver and output as a modulation on said RF beat frequency.

**10.** A source according to Claim 9, wherein said information source comprises a source of video signals.

**11.** A method of generating a radio frequency signal comprising:

(i) driving a semiconductor optical source (1) at a drive current sufficient to generate an optical output;

(ii) angle-modulating said optical output at a modulation frequency to generate optical sidebands in the optical output;
(iii) modifying a relative characteristic of said optical sidebands in the optical output; and
(iv) photodetecting said optical output to produce an electrical signal which comprises at least one radio frequency harmonic of said modulation frequency.

**12.** A method as claimed in claim 11, wherein the modification in step (iii) is achieved by propagating said optical output through a length of dispersive optical fibre (3).

**13.** A method of generating a free space microwave communications signal comprising:

(i) driving a semiconductor optical source (1) at a drive current sufficient to generate an optical output;
(ii) angle-modulating said optical output to generate optical sidebands in the optical output;
(iii) conducting the optical output through a length of dispersive optical fibre to modify the relative phases of the optical sidebands in the optical output;
(iv) photodetecting said optical output after its conduction through the optical fibre to produce an electrical signal which comprises at least one RF beat frequency between said sidebands; and
(v) feeding a said beat frequency included in said electrical signal to a microwave antenna.

**Patentansprüche**

**1.** Optisches Kommunikationssystem, das umfaßt:

eine optische Signalquelle (1), wobei die besagte Quelle im Betrieb einen optischen Ausgang hat, eine Modulationsvorrichtung (2), um eine Winkelmodulation in dem besagten optischen Ausgang bei einer Modulationsfrequenz zu erzeugen und dadurch optische Seitenbänder im optischen Ausgang hervorzurufen,

eine Modifizierungsvorrichtung (3) zum Modifizieren einer relativen Eigenschaft der optischen Seitenbänder in dem optischen Ausgang und um so die Photoerfassung von wenigstens einer Harmonischen der besagten Modulation bei einem Empfänger zu ermöglichen, der den besagten optischen Ausgang empfängt,

und einen Empfänger (4) zum Empfangen und Photoerfassen des optischen Ausgangs, um wenigstens eine hochfrequente Harmonische der besagten Modulationsfrequenz zu erzeugen.

**2.** System nach Anspruch 1, bei dem die Modifizierungsvorrichtung eine dispersive optische Faser umfaßt.

**3.** System nach Anspruch 1 oder 2, bei dem die optische Signalquelle ein distributed Feedback-Laser ist.

**4.** System nach Anspruch 3, bei dem die optische Signalquelle ein Split-contact-distributed-feedback-Laser ist.

**5.** System nach einem der Ansprüche 1 bis 4, bei dem die Modulationsvorrichtung operativ verbunden ist mit einer Informationsquelle, um das Einprägen von Informationskomponenten auf den optischen Ausgang und daher auf die hochfrequente Harmonische zu ermöglichen.

**6.** System nach Anspruch 5, bei dem die Informationsquelle eine Quelle für Videosignale umfaßt.

**7.** System nach einem der Ansprüche 1 bis 6, das außerdem eine Mikrowellenantenne (5) umfaßt, die im Betrieb die wenigstens eine Harmonische der Modulationsfrequenz nach der Photoerfassung durch den Empfänger (4) empfängt.

**8.** Radiofrequenzsignalquelle zur Verwendung in einem Kommunikationsystem, wobei die Quelle eine optische Signalquelle (1) umfaßt, welche im Betrieb einen optischen Ausgang hat, eine Modulationsvorrichtung (2), um Winkelmodulation in dem besagten optischen Ausgang zu erzeugen und dadurch optische Seitenbänder in dem optischen Ausgang hervorzurufen, und eine Modifikationsvorrichtung (3) mit einer Länge einer dispersiven optischen Faser, um die relativen Phasen der optischen Seitenbänder in dem optischen Ausgang zu modifizieren und dadurch die Photoerfassung von wenigstens einer RF-Schwebungsfrequenz zwischen den Seitenbändern bei einem Empfänger (4) zu ermöglichen, der den optischen Ausgang empfängt, und eine Vorrichtung, um die RF-Schwebungsfrequenz von dem Empfänger auszugeben zur Verwendung in einem Radiokommunikationssystem.

**9.** Quelle nach Anspruch 8, bei der eine Informationsquelle operativ verbunden ist mit der Modulationsvorrichtung, um eine informationsübertragende Modulation des optischen Ausgangs zu ermöglichen und damit eine Informationskomponente dadurch an den Empfänger und Ausgang als eine Modulation auf der besagten RF-Schwebungsfrequenz weitergereicht wird.

**10.** Quelle nach Anspruch 9, bei der die Informationsquelle eine Quelle von Videosignalen umfaßt.

**11.** Verfahren zum Erzeugen eines Radiofrequenzsignals, das umfaßt:

(i) Treiben einer optischen Halbleiterquelle (1) mit einem Treiberstrom, der ausreicht, einen optischen Ausgang zu erzeugen;

(ii) Winkelmodulation des optischen Ausgangs bei einer Modulationsfrequenz, um optische Seitenbänder in dem optischen Ausgang zu erzeugen,

(iii) Modifizieren einer relativen Eigenschaft der optischen Seitenbänder in dem optischen Ausgang; und

(iv) Photoerfassen des optischen Ausgangs, um ein elektrisches Signal zu erzeugen, welches wenigstens eine hochfrequente Harmonische der Modulationsfrequenz umfaßt.

**12.** Verfahren nach Anspruch 11, bei dem die Modifikation in Schritt (iii) erreicht wird durch Ausbreitung des optischen Ausgangs über eine Länge einer dispersiven optischen Faser (3).

**13.** Verfahren zum Erzeugen eines Freiraum-Mikrowellenkommunikationssignals, das umfaßt:

(i) Treiben einer optischen Halbleiterquelle (1) mit einem Treiberstrom, der ausreicht, einen optischen Ausgang zu erzeugen;

(ii) Winkelmodulation des optischen Ausgangs, um optische Seitenbänder in dem optischen Ausgang zu erzeugen;

(iii) Leiten des optischen Ausgangs durch eine Länge einer dispersiven optischen Faser, um die relativen Phasen der optischen Seitenbänder in dem optischen Ausgang zu modifizieren;

(iv) Photoerfassen des optischen Ausgangs nach dessen Leiten durch die optische Faser, um ein elektrisches Signal zu erzeugen, welches wenigstens eine RF-Schwebungsfrequenz zwischen den Seitenbändern hat; und

(v) Einspeisen einer Schwebungsfrequenz in dem elektrischen Signal in eine Mikrowellenantenne.

**Revendications**

**1.** Système de communications optique comprenant :

une source de signal optique (1), ladite source étant utilisée pour produire un signal de sortie optique, un moyen de modulation (2) pour produire une modulation angulaire dudit signal de sortie optique à une fréquence de modulation et pour faire apparaître ainsi des bandes latérales optiques dans le signal de sortie optique,
un moyen de modification (3) pour modifier une caractéristique relative des bandes latérales optiques dans le signal de sortie optique et pour permettre ainsi la photodétection d'au moins une harmonique de ladite modulation au niveau d'un récepteur recevant ledit signal de sortie optique,
et un récepteur (4) pour recevoir et effectuer la photodétection d'un signal de sortie optique pour produire au moins une harmonique à fréquence radio de ladite fréquence de modulation.

**2.** Système selon la revendication 1, dans lequel le moyen de modification comprend une fibre optique dispersive.

**3.** Système selon la revendication 1 ou la revendication 2, dans lequel ladite source de signal optique est un laser à

rétroaction répartie.

4. Système selon la revendication 3, dans lequel ladite source de signal optique est un laser à rétroaction répartie à contacts séparés.

5. Système selon l'une quelconque des revendications 1 à 4, dans lequel le moyen de modulation fonctionne en étant relié à une source d'informations pour permettre l'imposition d'une composante d'informations sur le signal de sortie optique et par conséquent sur ladite harmonique à fréquence radio.

6. Système selon la revendication 5, dans lequel ladite source d'informations comprend une source de signaux vidéo.

7. Système selon l'une quelconque des revendications 1 à 6, comprenant en outre une antenne hyperfréquence (5) qui reçoit en cours d'utilisation ladite harmonique, ou lesdites harmoniques, de ladite fréquence de modulation suite à la photodétection par le récepteur (4).

8. Source de signal à fréquence radio pour l'utilisation dans un système de communications, la source comportant une source de signal optique (1) qui est utilisée pour produire un signal de sortie optique, un moyen de modulation (2) pour produire une modulation angulaire dudit signal de sortie optique et pour faire ainsi apparaître des bandes latérales optiques dans le signal de sortie optique, et un moyen de modification (3) comportant une certaine longueur de fibre optique dispersive pour modifier les phases relatives des bandes latérales optiques dans le signal de sortie optique et permettre par conséquent la photodétection d'au moins une fréquence de battements RF entre lesdites bandes latérales au niveau d'un récepteur (4) recevant ledit signal de sortie optique, et un moyen pour produire ladite fréquence de battements RF en sortie du récepteur pour l'utilisation dans un système de communications radio.

9. Source selon la revendication 8, dans laquelle une source d'informations fonctionne en étant reliée au moyen de modulation pour permettre l'application d'une modulation véhiculant des informations au signal de sortie optique, et pour faire passer ainsi une composante d'informations au dit récepteur, et pour produire ainsi en sortie ladite composante d'informations en tant que modulation de ladite fréquence de battements RF.

10. Source selon la revendication 9, dans laquelle ladite source d'informations comprend une source de signaux vidéo.

11. Procédé de production d'un signal à fréquence radio comprenant les étapes consistant à :

(i) commander une source optique à semiconducteurs (1) à une intensité de courant de commande suffisante pour qu'elle émette un signal de sortie optique ;
(il) effectuer une modulation angulaire dudit signal de sortie optique à une fréquence de modulation pour engendrer des bandes latérales optiques dans le signal de sortie optique ;
(iii) modifier une caractéristique relative desdites bandes latérales optiques dans le signal optique de sortie; et
(iv) effectuer une photodétection dudit signal de sortie optique pour produire un signal électrique qui comprend au moins une harmonique à fréquence radio de ladite fréquence de modulation.

12. Procédé selon la revendication 11, dans lequel la modification à l'étape (iii) est effectuée par la propagation dudit signal de sortie optique le long d'une certaine longueur de fibre optique dispersive (3).

13. Procédé de production d'un signal de communications hyperfréquence en champ libre comprenant les étapes consistant à :

(i) commander une source optique à semiconducteurs (1) à une intensité de courant de commande suffisante pour qu'elle émette un signal de sortie optique ;
(il) effectuer une modulation angulaire dudit signal de sortie optique pour engendrer des bandes latérales optiques dans le signal de sortie optique ;
(iii) transmettre le signal de sortie optique le long d'une certaine longueur de fibre optique dispersive pour modifier les phases relatives des bandes latérales optiques dans le signal de sortie optique ;
(iv) effectuer la photodétection dudit signal de sortie optique après son passage dans la fibre optique pour produire un signal électrique qui comprend au moins une fréquence de battements RF entre lesdites bandes latérales ; et
(v) fournir une telle fréquence de battements incluse dans ledit signal électrique à une antenne hyperfréquence.

Fig.1.

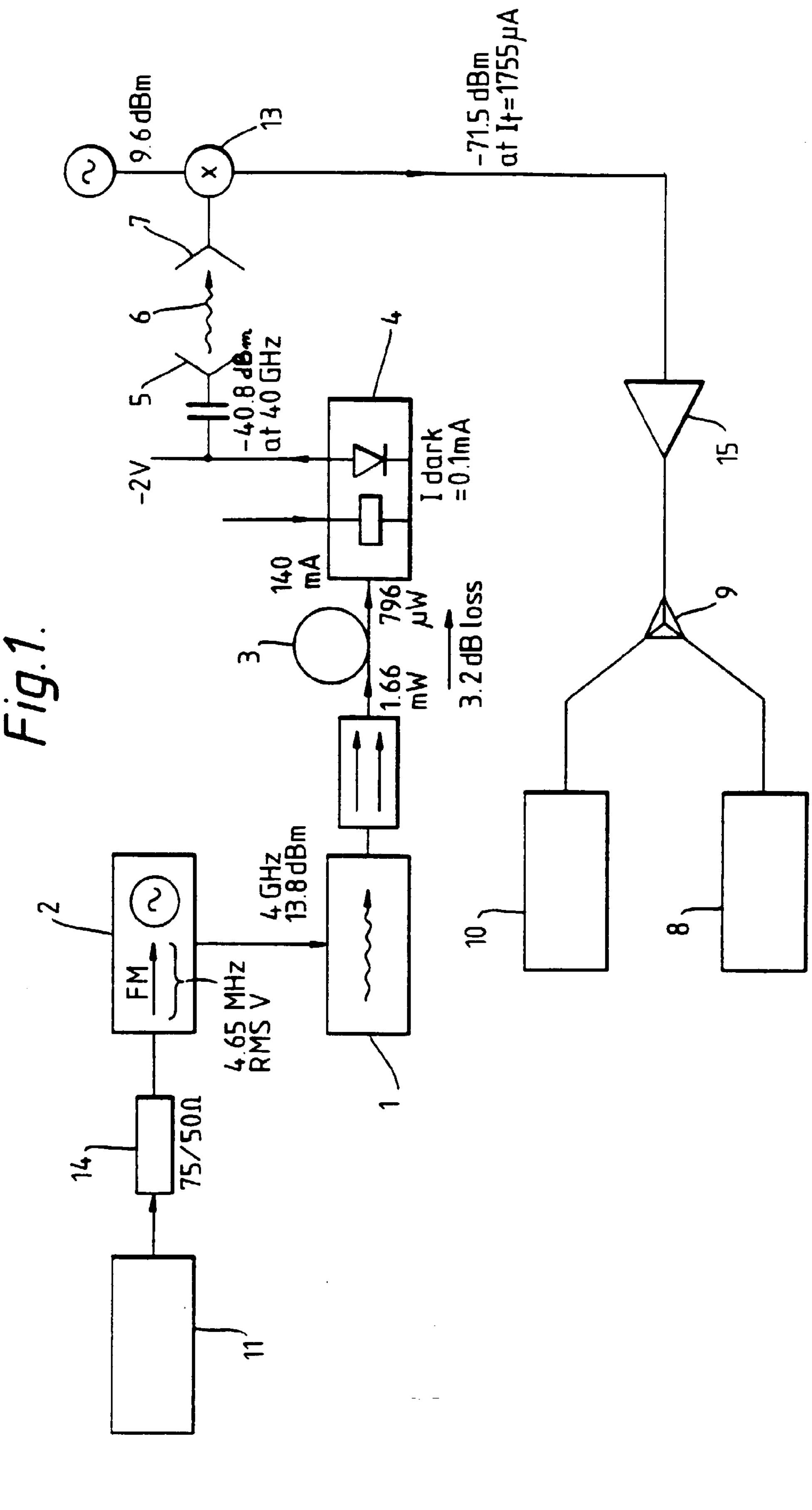
9.6 dBm
13
-71.5 dBm
at It=1755µA
7
6
5
-40.8 dBm
at 40 GHz
4
-2V
I dark
=0.1mA
140
mA
796
µW
3
1.66
mW
3.2 dB loss
9
15
2
FM
4 GHz
13.8 dBm
4.65 MHz
RMS V
1
14
75/50Ω
11
10
8

Fig. 2.

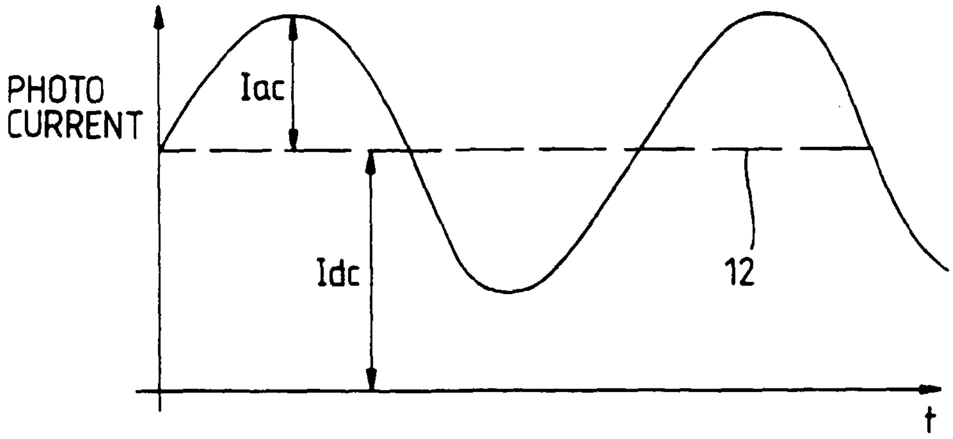


Fig. 3.

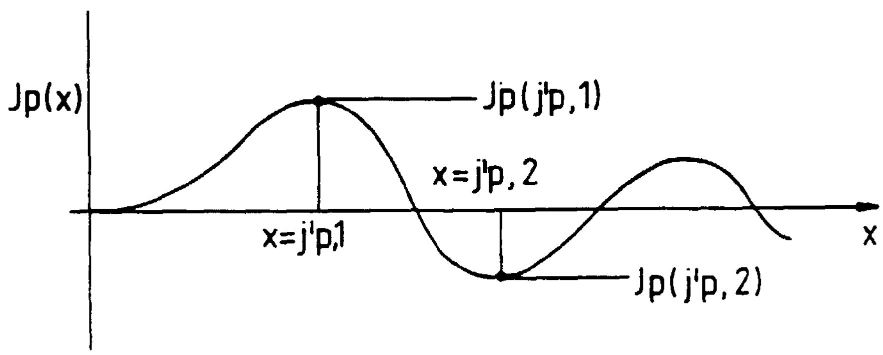


Fig. 4.

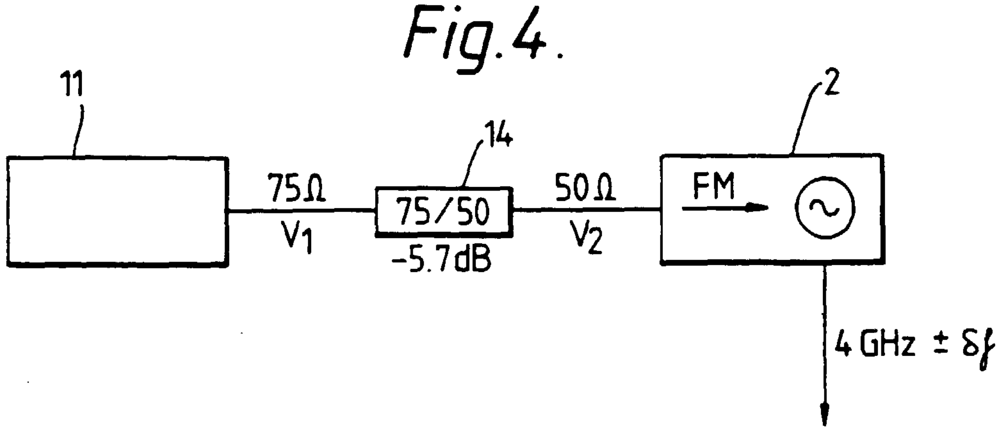

Fig. 5.

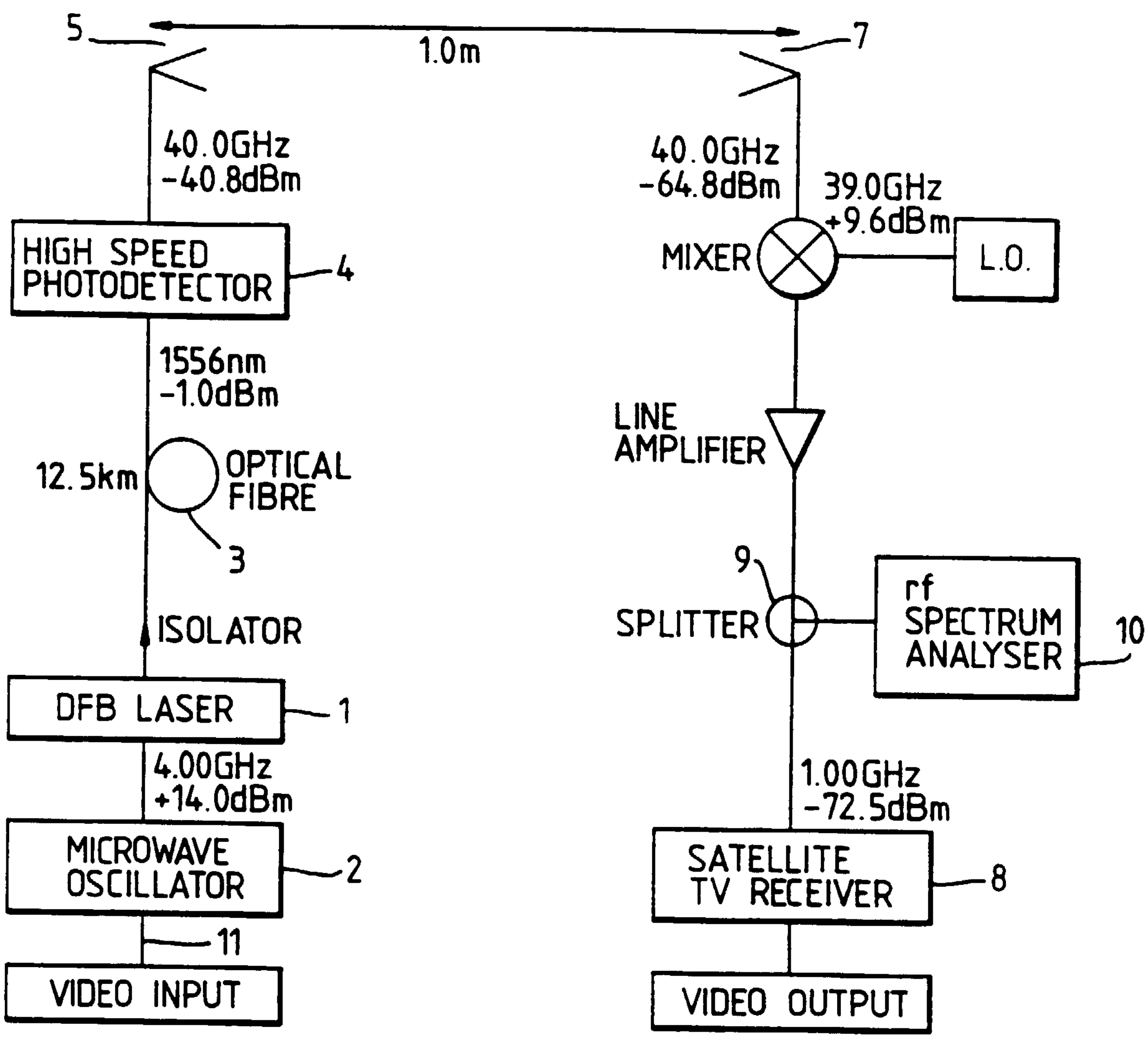
5
1.0m
7
40.0GHz
-40.8dBm
HIGH SPEED PHOTODETECTOR
4
1556nm
-1.0dBm
12.5km
OPTICAL FIBRE
3
ISOLATOR
DFB LASER
1
4.00GHz
+14.0dBm
MICROWAVE OSCILLATOR
2
11
VIDEO INPUT
40.0GHz
-64.8dBm
39.0GHz
+9.6dBm
MIXER
L.O.
LINE AMPLIFIER
9
SPLITTER
rf SPECTRUM ANALYSER
10
1.00GHz
-72.5dBm
SATELLITE TV RECEIVER
8
VIDEO OUTPUT

Fig. 6.

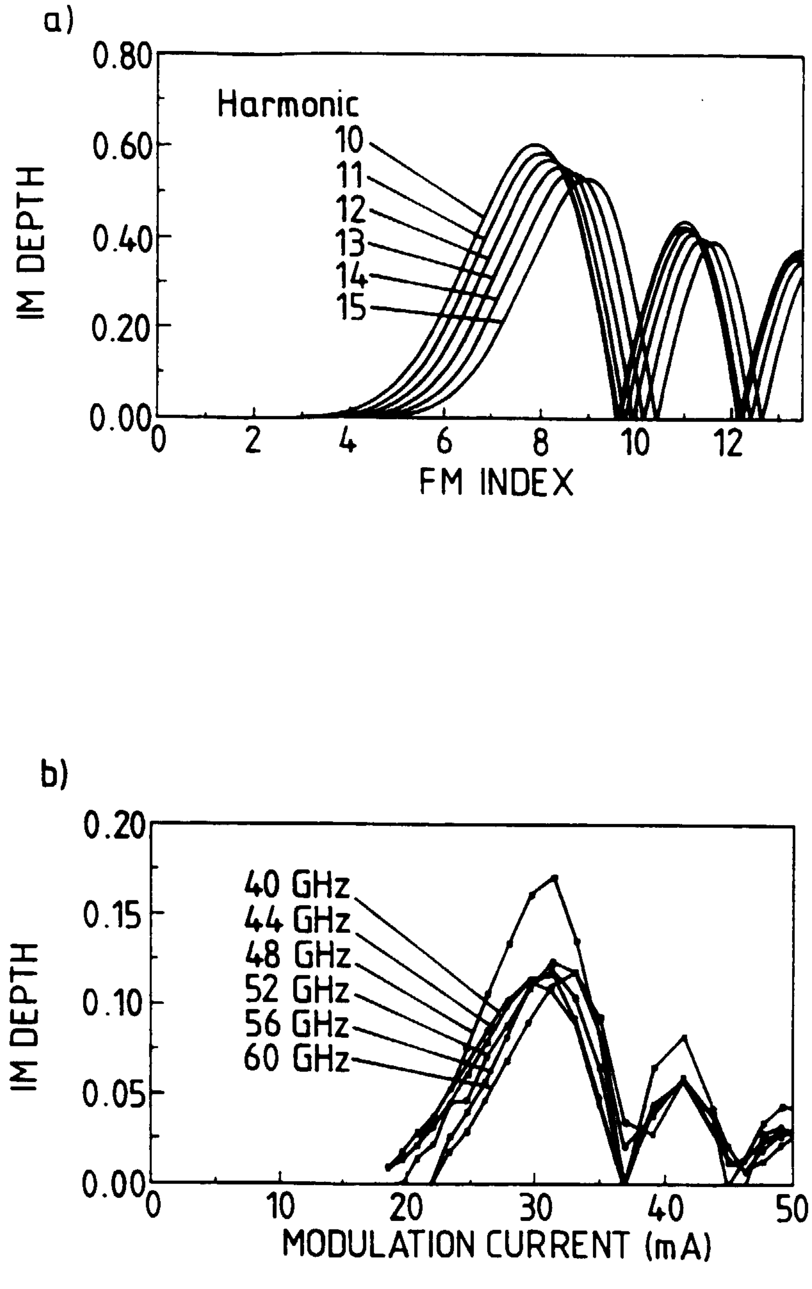


INTENSITY MODULATION (IM) DEPTH FOR 10th-15th HARMONICS

a) THEORETICAL DEPENDENCE ON FM INDEX FOR DISPERSION PARAMETER Ø = 0.027

b) MEASURED DEPENDENCE ON DRIVE CURRENT TO THE DFB LASER